# EUROPEAN PATENT APPLICATION

(11) **EP 4 664 520 A1**
(43) Date of publication of application: **17.12.2025**
(21) Application number: 24795949.7
(22) Date of filing: 18.04.2024
(51) Int. Cl.: H01L 23/373

(54) **TRANSISTOR, TRANSISTOR MANUFACTURING METHOD, AND ELECTRONIC DEVICE**

(30) Priority: 28.04.2023 CN 202310488328
(71) Applicant: Huawei Technologies Co., Ltd., Shenzhen, Guangdong 518129 (CN)
(72) Inventor: HU, Bin, Shenzhen, Guangdong 518129 (CN); RAO, Jin, Shenzhen, Guangdong 518129 (CN); HE, Tao, Shenzhen, Guangdong 518129 (CN); LU, Tianhao, Shenzhen, Guangdong 518129 (CN); DUAN, Huantao, Shenzhen, Guangdong 518129 (CN); LI, Haijun, Shenzhen, Guangdong 518129 (CN); ZHONG, Zheng, Shenzhen, Guangdong 518129 (CN)
(74) Representative: Maiwald GmbH
(86) International application number: PCT/CN2024/088645
(87) International publication number: WO 2024/222568

(57) **Abstract**

Embodiments of this application relate to the field of semiconductor technologies, and provide a transistor, a semiconductor device package structure, and an electronic device, to provide a process structure and an implementation of a transistor that can reduce thermal resistance. The transistor includes: a substrate, where the substrate has a first surface and a second surface that are opposite to each other, an active layer is disposed on a side of the first surface, and a metal layer is disposed on a side of the second surface; and a hole that penetrates the substrate and at least a part of the active layer, where in a direction from the substrate to the active layer, the hole includes a first hole segment and a second hole segment, a joint between the first hole segment and the second hole segment has a connection interface, a hole diameter of the first hole segment is greater than a hole diameter of the second hole segment, a conducting layer is formed on a wall surface of each of the first hole segment and the second hole segment, and the conducting layer is electrically connected to the metal layer. The first hole segment and the second hole segment are further filled with a heat dissipation material. For example, the heat dissipation material includes at least one of a silver material and a diamond material. A plurality of hole segments are disposed, and the hole is filled with the heat dissipation material, to improve heat dissipation of the active layer.

## Description

This application claims priority to Chinese Patent Application No. 202310488328.1, filed with the China National Intellectual Property Administration on April 28, 2023 and entitled "TRANSISTOR, TRANSISTOR PREPARATION METHOD, AND ELECTRONIC DEVICE", which is incorporated herein by reference in its entirety.

### TECHNICAL FIELD

This application relates to the field of semiconductor technologies, and in particular, to a transistor, a semiconductor device package structure having the transistor, and an electronic device having the semiconductor device package structure, and further to a transistor preparation method.

### BACKGROUND

With development of 5th generation mobile communication technologies (5th generation of wireless communications technologies, 5G), the communication field requires a higher frequency, a higher output power, and higher efficiency of a semiconductor device.

For example, the semiconductor device is a high-electron-mobility transistor (high-electron-mobility transistor, HEMT) device based on gallium nitride (gallium nitride, GaN). The HEMT device based on GaN mainly uses two-dimensional electron gas (two-dimensional electron gas, 2DEG) generated by a polarization effect at a heterojunction interface between aluminum gallium nitride (AlGaN) and gallium nitride (GaN), to achieve high electron mobility. Such a device has advantages such as a high withstand voltage, a high power density, and a high working speed.

Currently, high power advantages of both a radio frequency GaN HEMT device and a power GaN HEMT device are far from being fully utilized. For example, in the radio frequency GaN HEMT device, a high power performance advantage of the GaN device is not fully utilized due to a heat accumulation effect in an active region of the device. When a temperature of the device rises, characteristics such as a drain-source current, a gain, an output power, and a service life of the device deteriorate or even fail. The service life and reliability of the device are reduced by 50% each time a junction temperature is increased by 10°C.

Due to large thermal resistance of the device, heat dissipation becomes a main bottleneck that restricts further development and wide application of the GaN device.

### SUMMARY

This application provides a transistor, a semiconductor device package structure having the transistor, an electronic device having the semiconductor device package structure, and a transistor preparation method. A heat dissipation material, for example, silver or diamond, is filled in a hole whose wall surface is covered by a conducting layer, to reduce thermal resistance of a device and improve heat dissipation efficiency of the transistor.

To achieve the foregoing objectives, the following technical solutions are used in embodiments of this application.

According to an aspect, this application provides a transistor. For example, the transistor may be a high-electron-mobility transistor (high-electron-mobility transistor, HEMT) based on gallium nitride (gallium nitride, GaN).

A field-effect transistor includes a substrate. The substrate has a first surface and a second surface that are opposite to each other. An active layer is disposed on a side of the first surface, and a metal layer is disposed on a side of the second surface. The transistor further includes a hole that penetrates the substrate and at least a part of the active layer. In addition, in a direction from the substrate to the active layer, the hole includes a first hole segment and a second hole segment, a hole diameter of the first hole segment is greater than a hole diameter of the second hole segment, a joint between the first hole segment and the second hole segment has a connection interface, a conducting layer is formed on a wall surface of each of the first hole segment and the second hole segment, and the conducting layer is electrically connected to the metal layer. In addition, the first hole segment and the second hole segment are further filled with a heat dissipation material. For example, the heat dissipation material includes at least one of a silver material (for example, a porous silver material) and a diamond material.

In the transistor provided in this application, the hole whose wall surface is covered with the conducting layer can be used to electrically connect the active layer or a front electrode located on a side of the active layer to the metal layer. For example, the front electrode includes a source that needs to be grounded, and the source may pass through the hole having the conducting layer to be electrically connected to the metal layer that is used as a back electrode, to implement grounding. In addition, the hole may be further filled with the heat dissipation material. In this way, heat dissipated by the transistor may be diffused in time through the heat dissipation material, to reduce a junction temperature of the device and improve a heat dissipation effect of the device.

In addition, the hole in this application includes a first hole segment and a second hole segment that have different hole diameters, and the first hole segment with a larger hole diameter is closer to a hole opening than the second hole segment. In this way, when the heat dissipation material is filled in the hole, the first hole segment with a larger hole diameter is used, so that the heat dissipation material can be conveniently filled in an elongated hole, for example, filled in a hole with a size of 30 µm×75 µm, or filled in a hole with a size of 50 µm×100 µm.

In addition, the first hole segment with a large hole diameter is closer to the hole opening than the second hole segment. This not only facilitates filling the hole with the heat dissipation material from a process perspective, but also increase a filling amount of the heat dissipation material, to improve a heat dissipation effect.

In a possible implementation, the heat dissipation material includes at least one of a silver material and a diamond material.

For example, sintered silver may be filled in the hole through dispensing, to form a silver material layer structure. For another example, diamond may be grown in the hole by using a growth process, to form a diamond layer structure.

In a possible implementation, the heat dissipation material includes the silver material and the diamond material, and a mass fraction of the silver material is greater than a mass fraction of the diamond material.

From the process perspective, the heat dissipation material including the diamond and the sintered silver may be injected into the hole through the dispensing, so that adding diamond does not increase process difficulty. In terms of a heat dissipation effect of the device, because a thermal conductivity of the diamond is greater than a thermal conductivity of the silver, thermal resistance can be further reduced, and heat dissipation efficiency can be improved.

In a possible implementation, a diamond seed layer and a diamond layer are formed in the first hole segment and the second hole segment. In a radial direction of the first hole segment and the second hole segment, the diamond seed layer is formed on the conducting layer, and the diamond layer is formed on the diamond seed layer.

In a process that can be implemented, a growth process may be used. The diamond seed layer is first grown on the conducting layer, and then the diamond layer is grown on the diamond seed layer. In addition, the thermal conductivity of the diamond may reach at least 1000 W/mK, so that thermal resistance of the device is significantly reduced, and the heat dissipation effect is better.

In a possible implementation, a step is formed at the joint between the first hole segment and the second hole segment, and the step forms the connection interface. Alternatively, there is no step at the joint between the first hole segment and the second hole segment, but the first hole segment and the second hole segment are continuously connected together.

In a possible implementation, a bottom end that is of the first hole segment and that is away from the second surface is located in the substrate.

In a possible implementation, in a stacking direction of the substrate and the active layer, a depth of the first hole segment is greater than or equal to a depth of the second hole segment. For example, a ratio of the depth of the first hole segment to the depth of the second hole segment may be greater than or equal to 1:1, and less than or equal to 9:1.

In a possible implementation, in a direction from the active layer to the substrate, the hole diameter of the first hole segment is gradually increased. For example, the first hole segment may be of a horn-shaped structure, so that the hole is more likely to be filled with the heat dissipation material, and a probability that a gap or a hole-closing phenomenon occurs in the hole is reduced.

In a possible implementation, in the direction from the active layer to the substrate, the hole diameter of the second hole segment is gradually increased.

In a possible implementation, the transistor is a field-effect transistor, a source, a gate, and a drain are formed on a side that is of the active layer and that is away from the substrate; and the hole passes through the metal layer, the substrate, and the active layer to the source, and the source is electrically connected to the metal layer through the hole filled with the conducting layer.

In a possible implementation, the gate is located between the source and the drain; and an orthographic projection of the first hole segment on the gate covers at least a part of the gate.

In this type of device, more heat is dissipated in a region in which the gate is located. Therefore, the orthographic projection of the first hole segment on the gate covers at least a part of the gate, so that a heat dissipation path can be shortened, and heat dissipated from the region in which the gate is located may be diffused by the heat dissipation material in the hole as soon as possible, to reduce a highest junction temperature of the device.

In a possible implementation, the source extends in a first direction parallel to the substrate; the hole includes a first hole and a second hole that are separated from each other and arranged in the first direction; and the same source is electrically connected to the metal layer through the first hole and the second hole.

In a possible implementation, the source extends in a first direction parallel to the substrate; the hole includes a first hole and a second hole that are separated from each other and arranged in the first direction, and the first hole and the second hole that are arranged in the first direction are connected; and the same source is electrically connected to the metal layer through the first hole and the second hole.

In a possible implementation, the source extends in a first direction parallel to the substrate; a cross section that is of the hole and that is perpendicular to an axial direction of the hole is of a bar-shaped structure extending in the first direction; and the same source is electrically connected to the metal layer through the hole filled with the conducting layer and the heat dissipation material.

The hole is designed as the bar-shaped structure, so that an area of the hole can be increased, a filling amount of the heat dissipation material can be increased, and a highest junction temperature of the device can be further reduced.

In a possible implementation, a power of the field-effect transistor is greater than or equal to 100 W.

According to another aspect, this application further provides a field-effect transistor preparation method. The preparation method includes:
providing a hole that penetrates a substrate and at least a part of an active layer, where the substrate has a first surface and a second surface that are opposite to each other, and the active layer is disposed on a side of the first surface;
expanding a part that is of the hole and that is close to the second surface to form a first hole segment, where a remaining part of the hole forms a second hole segment, a hole diameter of the first hole segment is greater than a hole diameter of the second hole segment, and a joint between the first hole segment and the second hole segment has a connection interface;
forming a conducting layer on a wall surface of the first hole segment and a wall surface of the second hole segment, and forming a metal layer on a side of the second surface, where the conducting layer is electrically connected to the metal layer; and
filling the first hole segment and the second hole segment with a heat dissipation material.

In the preparation method, after the hole is provided in the substrate and the active layer, a part close to a hole opening is expanded to form the first hole segment with a large radial size, and then, the hole is filled with the heat dissipation material. In this way, the heat dissipation material is easily filled in an elongated hole. In addition, heat diffused by the active layer may be diffused by a heat dissipation material with a large thermal conductivity in the hole, to improve a heat dissipation effect.

In a possible implementation, filling the first hole segment and the second hole segment with the heat dissipation material includes:
filling the first hole segment and the second hole segment with sintered silver through dispensing; and
curing the sintered silver to form a silver material layer in the first hole segment and the second hole segment.

For example, the sintered silver may be injected into the hole through the dispensing, flow into the hole by using fluidity of the sintered silver, and then be cured, so that the sintered silver forms the silver material layer covering the conducting layer. Alternatively, heating the sintered silver to 50°C to 150°C can also improve fluidity of silver paste.

In a possible implementation, when the first hole segment and the second hole segment are filled with the sintered silver through the dispensing, the sintered silver is doped with diamond.

The diamond may be included in the sintered silver, and is injected into the hole through the dispensing. In this way, a process is not challenged, and the heat dissipation effect can be further improved by using diamond with a large thermal conductivity.

In a possible implementation, filling the sintered silver through the dispensing includes: under a high-temperature negative-pressure condition, enabling the dropped sintered silver to flow into the hole.

For example, through dispensing within a temperature range from 50°C to 150°C and under pressure less than 1000 mbar, the sintered silver automatically flows into a deep hole and reaches the bottom of the hole. Repeated dispensing and the high-temperature negative-pressure condition make the sintered silver fill up the hole of the entire device.

In a possible implementation, after curing the sintered silver to form the silver material layer in the first hole segment and the second hole segment, the preparation method further includes:
forming sintered silver on a surface of a heat dissipation flange; and
connecting a side that is of the substrate and that is away from the active layer to the heat dissipation flange through the sintered silver on the surface of the heat dissipation flange.

In a possible implementation, filling the first hole segment and the second hole segment with the heat dissipation material includes:
growing a diamond seed layer on the conducting layer in a radial direction of the first hole segment and the second hole segment; and
growing a diamond layer on the diamond seed layer.

A seed layer is first formed in the hole, and then a polycrystal or single crystal diamond layer is formed.

In a possible implementation, a source, a gate, and a drain are formed on a side that is of the active layer and that is away from the substrate, the source extends in a first direction parallel to the substrate, and the source is a front electrode; and providing the hole that penetrates the substrate and the active layer to the front electrode includes:
providing a bar-shaped hole extending in the first direction, for the same source to electrically connect to the metal layer through the bar-shaped hole filled with the conducting layer.

In this way, the formed hole can be filled with more heat dissipation materials, so that thermal resistance is reduced, and a highest junction temperature of the device is reduced.

According to still another aspect, this application further provides a semiconductor device package structure. The semiconductor device package structure includes the transistor in any one of the foregoing implementations or the transistor prepared in any one of the foregoing implementations. In addition, the semiconductor device package structure further includes a heat dissipation structure, and the heat dissipation structure is disposed on a side of the second surface of the substrate.

The semiconductor device package structure provided in this embodiment of this application includes the foregoing transistor. In the transistor, for example, the transistor may be a high-electron-mobility transistor. A hole used as a backside hole not only includes a first hole segment with a large hole diameter, but also includes a second hole segment with a small hole diameter. In this way, it is convenient to fill a heat dissipation material in an elongated hole. In addition, in this application, at least one of a silver material and a diamond material may be used as the heat dissipation material. In this way, from a process perspective, it is convenient to fill an elongated hole, and from a perspective of device performance, heat of the device may be diffused in time through the heat dissipation material, to reduce a junction temperature of the device.

In a possible implementation, the heat dissipation structure is connected through a silver material layer located between the heat dissipation structure and the metal layer, and the heat dissipation material in the hole is connected to the silver material layer.

In this way, the silver material layer not only serves as a connection structure for connecting the heat dissipation structure, but also serves as a heat dissipation channel, to further improve a heat dissipation effect of the field-effect transistor.

In a possible implementation, the heat dissipation material includes a diamond material. The semiconductor device package structure further includes a heat dissipation structure. The heat dissipation structure is disposed on a side of the second surface of the substrate. The heat dissipation structure is connected through a silver material layer located between the heat dissipation structure and the substrate.

In a possible implementation, the semiconductor device package structure further includes a cap, and the cap covers a side that is of the field-effect transistor and that is away from the heat dissipation structure.

According to still another aspect, this application further provides an electronic device, for example, a base station or a power charger of a terminal device. For example, the electronic device includes a drive circuit and the semiconductor device package structure in any one of the foregoing implementations, and the drive circuit is electrically connected to a transistor.

The electronic device provided in this embodiment of this application includes the foregoing field-effect transistor. Therefore, the electronic device provided in this embodiment of this application and the field-effect transistor in the foregoing technical solution can resolve a same technical problem and achieve a same expected effect.

### BRIEF DESCRIPTION OF DRAWINGS

FIG. 1 is a diagram of a partial structure of a base station;
FIG. 2 is a diagram of a package structure of a field-effect transistor according to an embodiment of this application;
FIG. 3 is a diagram of a structure of a field-effect transistor according to an embodiment of this application;
FIG. 4 is a diagram of a structure of a field-effect transistor according to an embodiment of this application;
FIG. 5 is a diagram of a structure of a field-effect transistor according to an embodiment of this application;
FIG. 6 is a diagram of a structure of a field-effect transistor according to an embodiment of this application;
FIG. 7 is a diagram of a structure of a field-effect transistor according to an embodiment of this application;
FIG. 8A is a diagram of a structure of a hole in a field-effect transistor according to an embodiment of this application;
FIG. 8B is a diagram of a structure of a hole in a field-effect transistor in a related technology;
FIG. 9 is a diagram of a structure of a field-effect transistor according to an embodiment of this application;
FIG. 10 is a diagram of a structure of a field-effect transistor according to an embodiment of this application;
FIG. 11 is a diagram of a three-dimensional structure of a field-effect transistor according to an embodiment of this application;
FIG. 12 is a diagram of a structure obtained after cutting along M-M in FIG. 11;
FIG. 13 is an N-direction view of FIG. 11;
FIG. 14 is a diagram of another structure obtained after cutting along M-M in FIG. 11;
FIG. 15 is another N-direction view of FIG. 11;
FIG. 16 is a diagram of a structure including a field-effect transistor according to an embodiment of this application;
FIG. 17 is a diagram of a structure of a field-effect transistor according to an embodiment of this application;
FIG. 18 is a diagram of a structure including a field-effect transistor according to an embodiment of this application;
FIG. 19A to FIG. 19I are cross-sectional views of a corresponding process structure after steps in a field-effect transistor manufacturing method are completed according to an embodiment of this application;
FIG. 20 is a diagram of a structure of a field-effect transistor according to an embodiment of this application;
FIG. 21 is a diagram of a structure including a field-effect transistor according to an embodiment of this application;
FIG. 22A is a diagram of a structure of a hole in a field-effect transistor according to an embodiment of this application;
FIG. 22B is a diagram of a structure of a hole in a field-effect transistor according to an embodiment of this application; and
FIG. 23A to FIG. 23E are cross-sectional views of a corresponding process structure after steps in a field-effect transistor manufacturing method are completed according to an embodiment of this application.

### Reference numerals:

101: field-effect transistor; 102: heat dissipation structure; 103: ceramic frame; 104: cap;
10: substrate;
20: active layer;
201: nucleation layer;
202: channel layer;
203: barrier layer;
301: source;
302: gate;
303: drain;
40: back electrode;
50: hole; 501: first hole segment; 502: second hole segment;
50A: first hole; 50B: second hole;
60: conducting layer;
70: heat dissipation material; 701: diamond seed layer; 702: diamond layer;
300: connection layer;
400: heat dissipation flange;
500: heat sink; and
600: air bridge.

### DESCRIPTION OF EMBODIMENTS

An embodiment of this application provides an electronic device. The electronic device may include a communication device (for example, a base station), a wireless charging device, a medical device, a radar, a navigation device, a radio frequency (radio frequency, RF) plasma lighting device, an RF sensing and microwave heating device, and the like. A specific form of the electronic device is not specially limited in embodiments of this application.

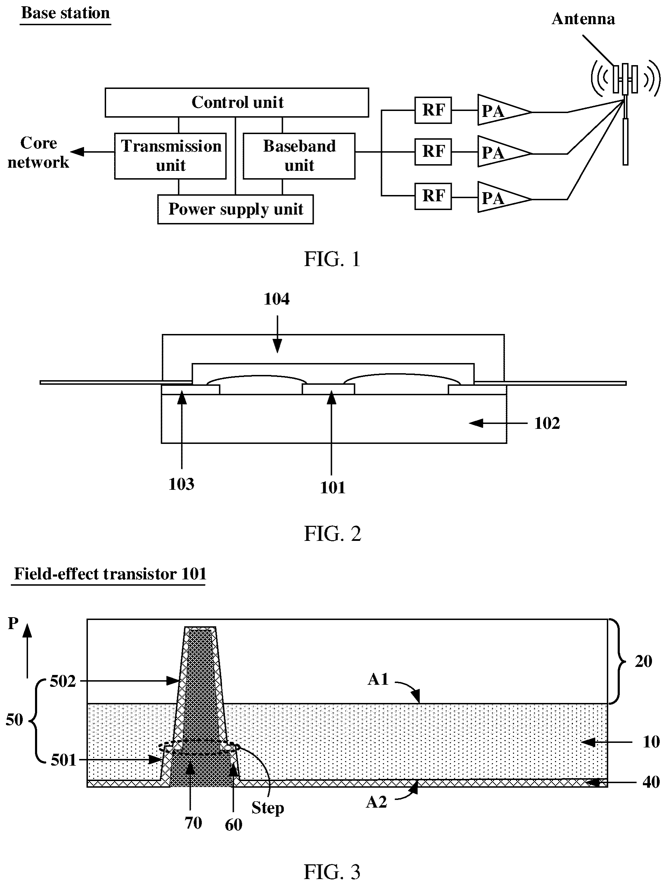

The foregoing electronic device basically includes a semiconductor device, for example, includes a power amplifier (power amplifier, PA). A main function of the PA is to amplify a radio frequency signal. A base station is used as an example. FIG. 1 is a simple diagram of a structure of the base station. The base station includes a control unit, the control unit in the base station includes a radio transceiver, an antenna, a related signal processing circuit, and the like. The control unit mainly includes a cell controller, a voice channel controller, a signaling channel controller, and a multi-channel interface for extension. The control unit of the base station generally controls several base station transceiver stations. Through remote commands of the transceiver stations and mobile stations, the control unit of the base station is used to implement management of all mobile communication interfaces, mainly including radio channel allocation, release, management, and the like.

Still with reference to FIG. 1, the base station further includes a transmission unit, where the transmission unit is connected to a core network, control signaling on a core network side and voice call or data service information are sent to the control unit of the base station through the transmission unit, and the control unit processes the services.

With reference to FIG. 1, the base station further includes a baseband unit and a radio frequency (radio frequency, RF) unit. The baseband unit mainly completes functions such as baseband modulation and demodulation, wireless resource allocation, call processing, power control, and soft handover. The RF unit mainly completes conversion between an air radio frequency channel and a baseband digital channel, a power amplifier (power amplifier, PA) amplifies a signal, and then the signal is sent to an antenna via a radio frequency feeder for transmission. A terminal device, like a mobile phone (mobile phone) or a tablet computer (pad), receives, through a wireless channel, a radio wave transmitted by the antenna, and then obtains, through demodulation, a signal belonging to the terminal device.

Still with reference to FIG. 1, the base station further includes a power supply unit, where the power supply unit may be configured to supply power to structures such as the transmission unit, the baseband unit, and the control unit.

In addition, a semiconductor power device is also used in a power charger of a terminal device like a mobile phone, for example, a switch chip in a charger whose power is 60 W, 100 W, 300 W, or the like.

With development of 4th generation mobile communication technologies (4th generation of wireless communications technologies, 4G) to 5th generation mobile communication technologies (5th generation of wireless communications technologies, 5G), a function requirement for the foregoing semiconductor device is increasingly high, for example, having a higher frequency, a higher voltage, and a higher output power and efficiency.

Among selectable semiconductor materials, gallium nitride (GaN) becomes a key material for manufacturing a semiconductor device because of its high thermal conductivity, high breakdown field strength, and high saturation electron mobility. For example, a high-electron-mobility transistor (high-electron-mobility transistor, HEMT) based on gallium nitride (gallium nitride, GaN) is manufactured by using a GaN epitaxial single-crystal thin film grown on a single-crystal substrate. The single-crystal substrate generally uses a material such as a sapphire (Sapphire), silicon carbide (SiC), or silicon (Si) single crystal. For example, when the substrate uses a silicon single-crystal material, a manufactured HEMT may be referred to as a gallium nitride on silicon (GaN-on-Si) HEMT device.

A field-effect transistor in the foregoing device may use a package structure shown in FIG. 2, and the package structure may be referred to as a ceramic tube-housing package. Because the field-effect transistor 101 is usually a high-power chip, for example, a chip with high power that may be greater than or equal to 100 W. To ensure working performance of the field-effect transistor, the field-effect transistor 101 is disposed on a heat dissipation structure 102, and the field-effect transistor 101 is connected to a ceramic frame (ceramic frame) 103 through a lead. Then, the field-effect transistor 101 is led out through gold wire bonding, to be electrically connected to a drive circuit. In addition, the package structure further includes a cap (cap) 104, and the field-effect transistor 101 is covered by the cap 104.

The field-effect transistor 101 shown in FIG. 2 may include a structure shown in FIG. 3. With reference to FIG. 3, FIG. 3 is a sectional view of the field-effect transistor 101 according to an embodiment of this application. The field-effect transistor 101 includes a substrate 10, and an active layer 20 formed on the substrate 10.

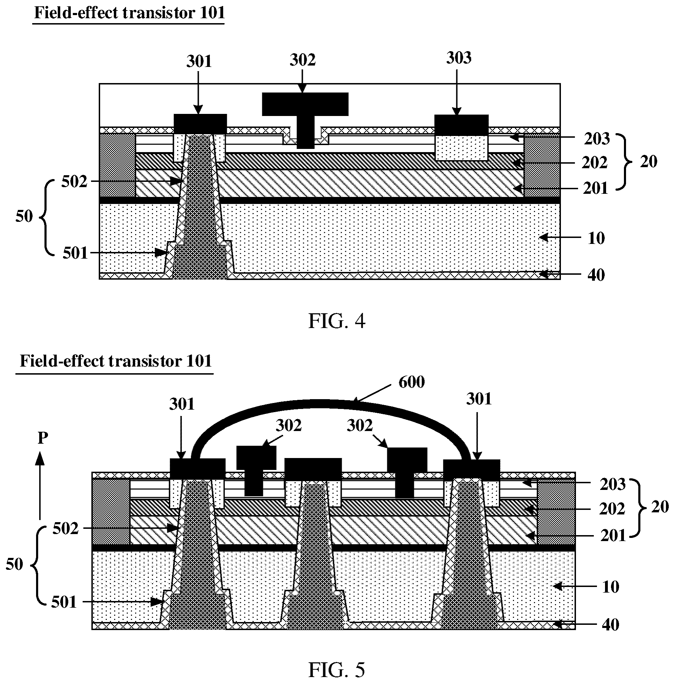

For example, as shown in FIG. 4, the active layer 20 may include a nucleation layer 201, a channel layer 202 formed on the nucleation layer 201, and a barrier layer 203 formed on the channel layer 202. In other words, film layer structures such as the nucleation layer 201, the channel layer 202, and the barrier layer 203 are sequentially stacked on the substrate 10 in a direction perpendicular to the substrate 10.

Still with reference to FIG. 4, in the field-effect transistor 101, the nucleation layer 201, the channel layer 202, and the barrier layer 203 may include at least one of aluminum nitride (AlN), gallium nitride (GaN), indium nitride (InN), aluminum gallium nitride (AlGaN), indium gallium nitride (InGaN), aluminum indium gallium nitride (AlInGaN), and the like.

For example, the nucleation layer 201 may include an aluminum nitride (AlN) material, aluminum gallium nitride (AlGaN), or the like.

FIG. 4 merely shows an example of some film layer structures included in the active layer 20 in the field-effect transistor 101. Certainly, more film layer structures may be added based on this embodiment, or some film layer structures may be removed. For example, the active layer 20 may further include a stress buffer layer, an insertion layer, a cap layer, and the like. The stress buffer layer is stacked between the nucleation layer 201 and the channel layer 202, the insertion layer is stacked between the channel layer 202 and the barrier layer 203, and the cap layer is stacked on the barrier layer 203. These active layer structures integrated on the substrate 1 are not specially limited in this application.

The field-effect transistor 101 shown in FIG. 3 and FIG. 4 dissipates heat during operation. For example, in a radio frequency GaN HEMT device or a power GaN HEMT device, as a power of the device increases, a temperature increases more obviously, and a junction temperature increases.

To improve a heat dissipation effect of the device and reduce thermal resistance, as shown in FIG. 3, a hole 50 is provided in the field-effect transistor 101, and the hole 50 penetrates the substrate 10 and at least a part of the active layer 20.

In addition, the hole 50 is filled with a heat dissipation material. In this way, heat dissipated by the active layer 20 may be conducted to the hole, and the heat is diffused by using the heat dissipation material.

In some examples, as shown in FIG. 4, the field-effect transistor 101 includes a source (Source) 301, a gate (Gate) 302, and a drain (Drain) 303. The source 301, the gate 302, and the drain 303 are formed on a side that is of the active layer 20 and that is away from the substrate 10.

In some scenarios, the gate 302 needs to be electrically connected to a control circuit. For example, as shown in FIG. 2, the field-effect transistor 101 may be electrically connected to the drive circuit through gold wire bonding, to control on and off of the gate 302.

In some other scenarios, the source 301 may be grounded. For example, a back electrode 40 may be disposed on a side that is of the substrate 10 and that is away from the active layer 20. Further, the hole 50 may sequentially penetrate the substrate 10 and the active layer 20 from the back electrode 40 until the source 301. In addition, a conducting layer 60 may be formed on a wall surface (including a side surface of the hole and a bottom surface of the hole) of the hole 50, and the conducting layer 60 is electrically connected to the back electrode 40. For example, the conducting layer 60 may also be a back electrode, for example, a nickel layer and a gold layer, to implement grounding of the source 301. For example, a thin nickel layer may be first formed on the wall surface of the hole 50, and then a thick gold layer is formed on the nickel layer. This hole 50 may also be referred to as a backside hole, and the back electrode 40 may be referred to as a back electrode.

In an implementable process, the conducting layer 60 and the back electrode 40 are made of a same material, and may be completed at a time. For example, a layer of nickel may be deposited first, and then a layer of gold material is deposited on the nickel material layer.

FIG. 4 is an example. In this example, the hole 50 passes through the back electrode 40, the substrate 10, and the active layer 20 until the source 301.

In another example, the structure shown in FIG. 5 is similar to the structure shown in FIG. 4, and both structures may belong to a GaN HEMT device. The structure shown in FIG. 5 belongs to a GaN HEMT device of an air bridge. In the device, two sources 301 may be electrically connected through an air bridge 600. Similarities between the example shown in FIG. 5 and the example shown in FIG. 4 further include that the conducting layer 60 and a heat dissipation material 70 are filled in the hole 50 for electrically connecting the source 301 to the back electrode 40.

With reference to FIG. 3 to FIG. 5, it may be understood that in different embodiments provided in this application, the substrate 10 has a first surface A1 and a second surface A2 that are opposite to each other, the active layer 20 is disposed on a side of the first surface A1, the back electrode 40 is disposed on a side of the second surface A2, and the hole 50 penetrates the back electrode 40, the substrate 10, and at least a part of the active layer 20. The conducting layer 60 in the hole 50 may be used to implement interconnection between a structure on a side of an active surface (a surface having the active layer) of the device and the back electrode 40 on a passive surface (a surface of the substrate).

In the examples of this application shown in FIG. 3 to FIG. 5, the heat dissipation material 70 may include at least one of a porous silver material and a diamond material. For example, the heat dissipation material 70 may be a porous silver material. For another example, the heat dissipation material 70 may be a diamond material. For another example, the heat dissipation material 70 may be a mixture of the porous silver material and the diamond material. The diamond material in this embodiment may be understood as at least one of polycrystal diamond (Polycrystal diamond) and single crystal diamond (Single crystal diamond).

The hole 50 in this embodiment of this application has an elongated feature. For example, a depth size of the hole 50 is basically about 100 µm or greater than 100 µm, and a radial size of the hole 50 may be about 20 µm. For example, a size of the hole 50 is 30 µm × 75 µm, or a size of the hole is 50 µm×100 µm. For example, a depth size of the hole 50 is twice a radial size.

During preparation using a process, it is convenient to fill the heat dissipation material 70 into the elongated hole 50. Refer to FIG. 3 to FIG. 5. For the hole 50 in this embodiment of this application, in a direction from the substrate 10 to the active layer 20 (for example, a direction P in FIG. 3), the hole 50 includes a first hole segment 501 and a second hole segment 502, and a hole diameter size of the first hole segment 501 is greater than a hole diameter size of the second hole segment 502. In this design, the first hole segment 501 that is close to an opening of the hole 50 and that has a large hole diameter is used, so that the heat dissipation material 70 is easily filled in an elongated hole.

The hole diameter size of the first hole segment 501 and the hole diameter size of the second hole segment 502 in this embodiment of this application may be understood as a size of the first hole segment 501 in a direction perpendicular to an axial direction of the first hole segment 501, and a size of the second hole segment 502 in a direction perpendicular to an axial direction of the second hole segment 502.

In some examples, as shown in FIG. 3, in a direction from a second surface A2 to a first surface A1 of the substrate 10, a radial size of the first hole segment 501 is gradually decreased. In some other examples, in a direction from a second surface A2 to a first surface A1 of the substrate 10, a radial size of the second hole segment 502 may also be gradually decreased.

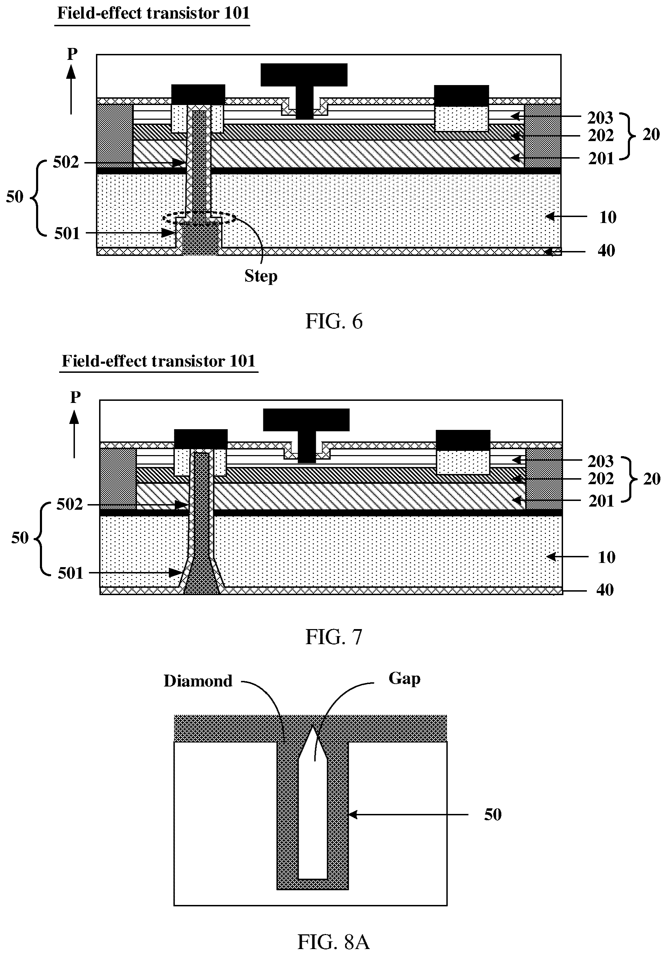

In some other examples, as shown in FIG. 6, in a direction (for example, a direction P in FIG. 6) from a second surface A2 to a first surface A1 of the substrate 10, a radial size of the first hole segment 501 remains unchanged. In some other examples, in a direction from a second surface A2 to a first surface A1 of the substrate 10, a radial size of the second hole segment 502 may also remain unchanged.

Still refer to FIG. 6. In this embodiment of this application, a bottom end of the first hole segment 501 is located in the substrate 10. Certainly, in some implementable structures, the first hole segment 501 with a large hole diameter may also pass through the substrate 10 to the active layer 20.

As shown in FIG. 6, in a stacking direction of the substrate 10 and the active layer 20, a depth of the first hole segment 501 may be greater than or equal to a depth of the second hole segment 502 (a size in the P direction), or a depth of the first hole segment 501 may be less than a depth of the second hole segment 502. For example, a ratio of the depth of the first hole segment 501 to the depth of the second hole segment 502 may be greater than or equal to 1:1, and less than or equal to 9:1.

A structure at a joint between the first hole segment 501 and the second hole segment 502 also has a plurality of cases. For example, as shown in FIG. 6, a step is formed at the joint between the first hole segment 501 and the second hole segment 502. For another example, as shown in FIG. 7, no step is formed at the joint between the first hole segment 501 and the second hole segment 502, but the first hole segment 501 and the second hole segment 502 are continuously connected together. Regardless of FIG. 6 or FIG. 7, the joint between the first hole segment 501 and the second hole segment 502 has a connection interface.

The foregoing merely shows an example in which the hole 50 has one step. In some other examples, a plurality of steps may alternatively be formed because radial sizes of adjacent hole segments are different.

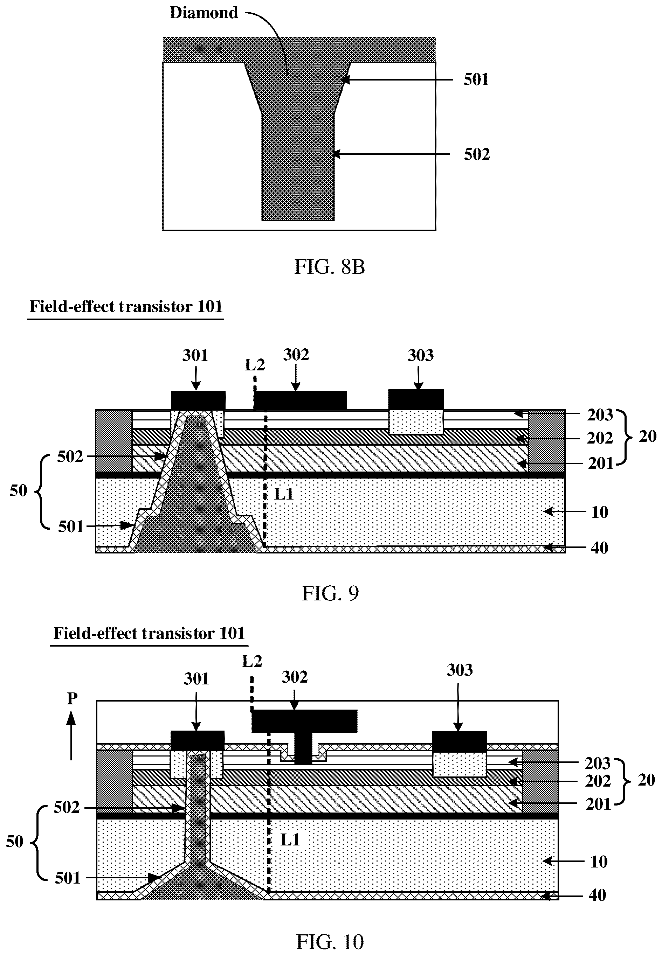

FIG. 8A and FIG. 8B show holes of two different structures. FIG. 8A shows a hole structure of a same radial size, and FIG. 8B shows a hole structure including the first hole segment 501 with a large hole diameter and the second hole segment 502 with a small hole diameter according to an embodiment of this application. In this case, when diamond is separately grown in the hole 50 in FIG. 8A and FIG. 8B, a phenomenon of opening closure easily occurs in FIG. 8A, to be specific, an opening at which the diamond is grown is closed, but the interior of the opening is not fully grown with diamond, and a large gap is generated. However, when the hole structure shown in FIG. 8B is used, a phenomenon of opening closure basically does not occur, so that the hole is basically filled with diamond, and a heat dissipation effect is improved.

As shown in FIG. 9 and FIG. 10, in the field-effect transistor 101 including the active layer 20, the source 301, the gate 302, and the drain 303, a large amount of heat is dissipated from an active region in which the gate 302 is located. To further improve heat dissipation below the gate 302, as shown in FIG. 9 and FIG. 10, an orthographic projection of the hole 50 on the gate 302 needs to cover at least a part of the gate 302. As shown in FIG. 9, a boundary L1 of the first hole segment 501 of the hole 50 may be located within a boundary L2 of the gate 302. Alternatively, as shown in FIG. 10, a hole diameter size of the first hole segment 501 may be increased, so that the opening is in a horn-shaped structure. According to the examples in FIG. 9 and FIG. 10, a heat conduction path below the gate 302 may be shortened, so that the heat is quickly absorbed by the heat dissipation material 70 in the hole 50.

For example, in the structures shown in FIG. 9 and FIG. 10, the radial size of the first hole segment 501 may be at least twice the radial size of the second hole segment 502, for example, may be twice or three times the radial size of the second hole segment 502. For example, when the radial size of the second hole segment 502 is 20 µm, the radial size of the first hole segment 501 may be 50 µm.

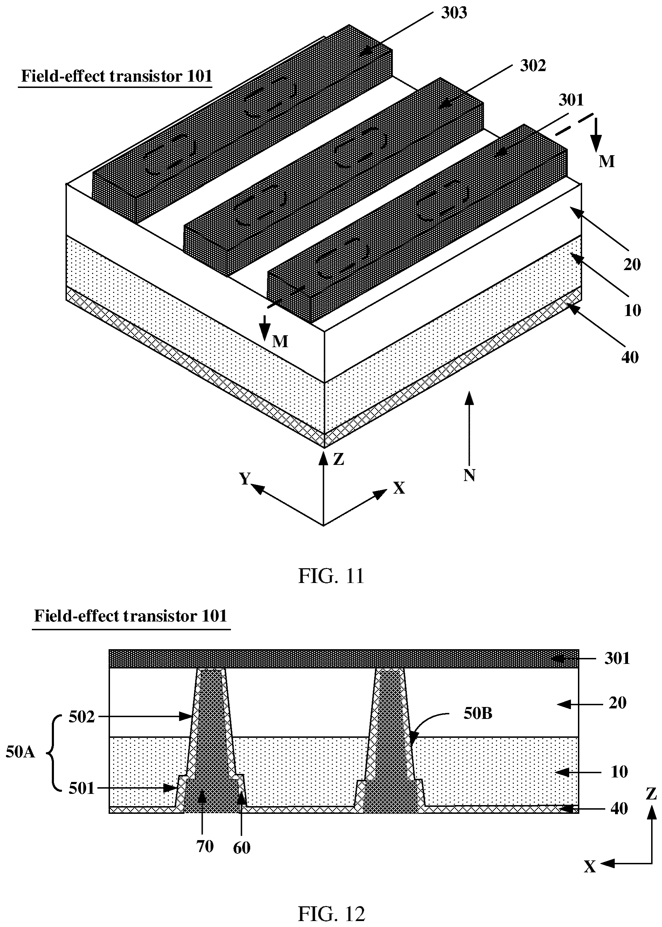

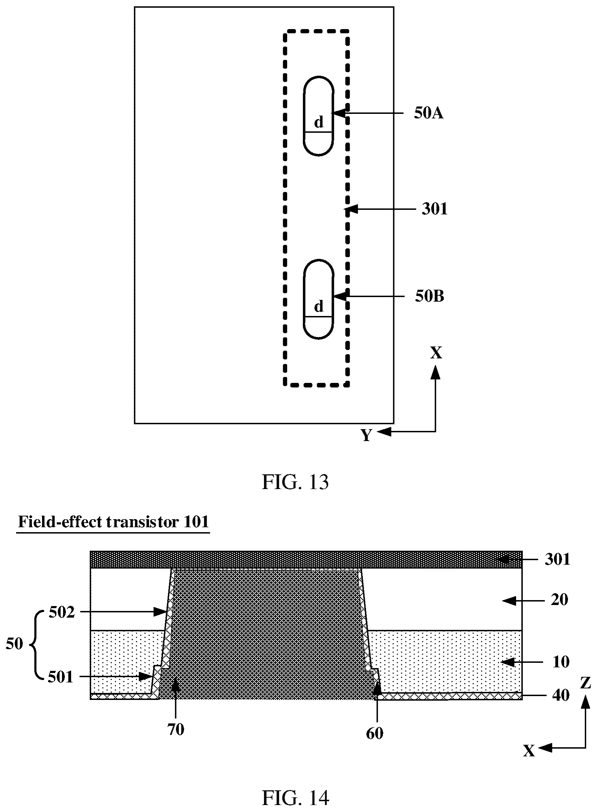

Some field-effect transistors 101 may include a plurality of holes 50. For example, as shown in FIG. 11, FIG. 12, and FIG. 13, FIG. 11 shows an example of a diagram of a three-dimensional structure including the substrate 10, the active layer 20, the source 301, the gate 302, the drain 303, and the back electrode 40 that is used as a grounding layer, FIG. 12 is a cross-sectional view obtained after cutting in an M-M direction in FIG. 11, and FIG. 13 is an N-direction view of FIG. 11. With reference to FIG. 11 to FIG. 13, the source 301 extends in a direction parallel to the substrate 10 (for example, in an X direction), and the source 301 is electrically connected to the back electrode 40 through a plurality of holes 50. For example, in FIG. 12 and FIG. 13, it is shown that the plurality of holes 50 include a first hole 50A and a second hole 50B that are separated from each other, and the first hole 50A and the second hole 50B are arranged and are spaced from each other in the X direction. In addition, each hole includes the first hole segment 501 with a large hole diameter and the second hole segment 502 with a small hole diameter.

FIG. 11 simply shows that one source 301 is electrically connected to the back electrode 40 through two holes 50. In a process structure, both the two holes 50 penetrate the back electrode 40 to the source 301.

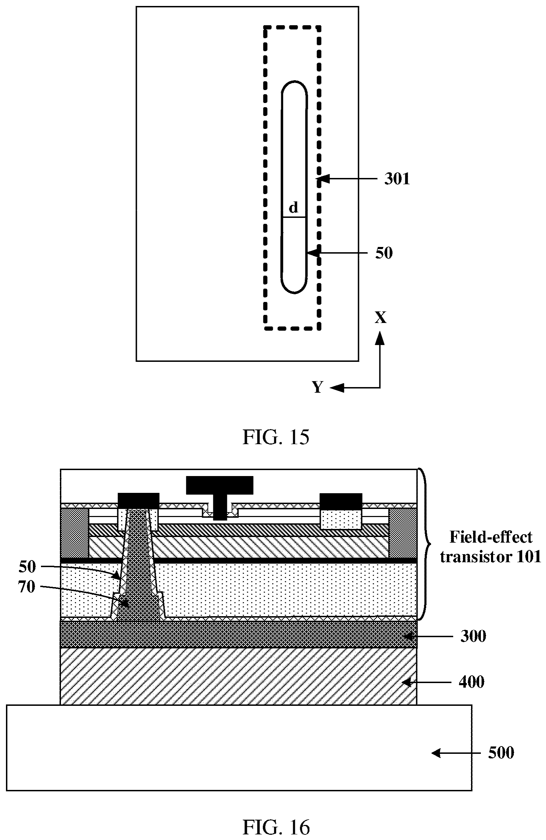

In some other examples, to further improve a heat dissipation effect, FIG. 14 and FIG. 15 show another implementable structure in which the same source 301 is electrically connected to the back electrode 40 through the hole 50, and FIG. 15 is a bottom view of FIG. 14. Through comparison between FIG. 14 and FIG. 12, in FIG. 15, the same source 301 is electrically connected to the back electrode 40 through one hole 50, instead of being electrically connected to the back electrode 40 through a plurality of holes that are separated and spaced from each other. To be specific, in FIG. 14, the first hole 50A and the second hole 50B shown in FIG. 12 may be connected, in other words, a cross section that is of the hole 50 in FIG. 14 and that is perpendicular to an axial direction of the hole 50 extends in a direction consistent with an extension direction of the source 301.

In this design, on the basis of implementing the electrical connection between the source 301 and the back electrode 40, a wall surface area of the hole 50 may be further increased, so that a filling amount of the heat dissipation material 70 is increased and the heat dissipation effect is improved.

With reference to FIG. 13 and FIG. 15, in the hole 50 in this embodiment of this application, a cross section perpendicular to the axial direction of the hole is of an elliptical structure. In this case, hole diameters of the first hole segment 501 and the second hole segment 502 of the hole 50 may be understood as sizes d in minor-axis directions of ellipses shown in FIG. 13 and FIG. 15. In some other embodiments, a cross section that is of the hole 50 and that is perpendicular to the axial direction of the hole may alternatively be of a circular structure. In this case, hole diameters of the first hole segment 501 and the second hole segment 502 of the hole 50 may be understood as a diameter of a circle.

As shown in FIG. 16, the field-effect transistor 101 may be disposed on a heat dissipation flange (for example, a copper flange is a package flange) 400 through a connection layer 300, and the heat dissipation flange 400 is disposed on a heat sink 500 (which may also be referred to as a tube housing). Some heat dissipated by the field-effect transistor 101 may be conducted to the heat dissipation flange 400 and the heat sink 500 through the connection layer 300, to reduce a device temperature.

The foregoing provides a description that materials that may be selected for the heat dissipation material 70 provided in this application may include at least one of a porous silver material and a diamond material. For example, in the field-effect transistor 101 shown in FIG. 16, the heat dissipation material 70 includes the porous silver material. In this case, the connection layer 300 may alternatively be made of a silver material, and the heat dissipation material 70 in the hole 50 may be connected to the silver material used as the connection layer 300.

In this way, the silver material layer used as the connection layer 300 may also be used as a heat dissipation channel, to improve heat dissipation efficiency of the field-effect transistor 101.

In the foregoing embodiment, the heat dissipation material 70 may be the porous silver material. In some examples, content of the silver material in the heat dissipation material 70 is 95% to 98%, and the heat dissipation material 70 may be mixed with a substance such as another oxide.

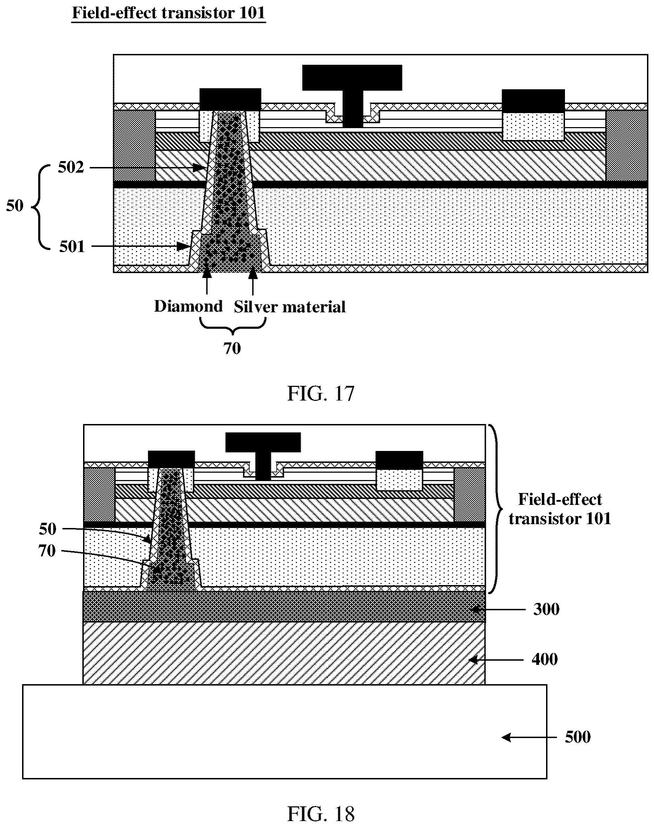

FIG. 17 is a diagram of a process structure of another field-effect transistor 101 according to an embodiment of this application. A difference between this embodiment and the foregoing embodiment is that the heat dissipation material 70 not only includes a porous silver material, but also may include diamond, that is, is a mixture of diamond and the porous silver material. For example, the diamond may be single crystal diamond. Because a thermal conductivity of the single crystal diamond is greater than 2000 W/mK, a thermal resistance of the device can be further reduced, and heat dissipation efficiency can be improved.

In some examples, a mass fraction of the silver material in the heat dissipation material 70 may be greater than a mass fraction of the diamond material. For example, the mass fraction of the diamond material is 20% to 40%, and the mass fraction of the silver material is 60% to 80%.

FIG. 18 is a diagram of a structure in which the field-effect transistor 101 shown in FIG. 17 is integrated on a heat dissipation flange (for example, a copper flange is a package flange) 400 and the heat dissipation flange 400 is disposed on the heat sink 500. In this implementation structure, the connection layer 300 may alternatively be made of a silver material, and the porous heat dissipation material 70 in the hole 50 may be connected to the silver material used as the connection layer 300. The silver material layer used as the connection layer 300 may also be used as a heat dissipation channel, to improve heat dissipation efficiency of the field-effect transistor 101.

The following provides a semiconductor device preparation method. In the field-effect transistor 101 prepared by using the method, a heat dissipation material in a hole includes a silver material. A specific preparation process is as follows.

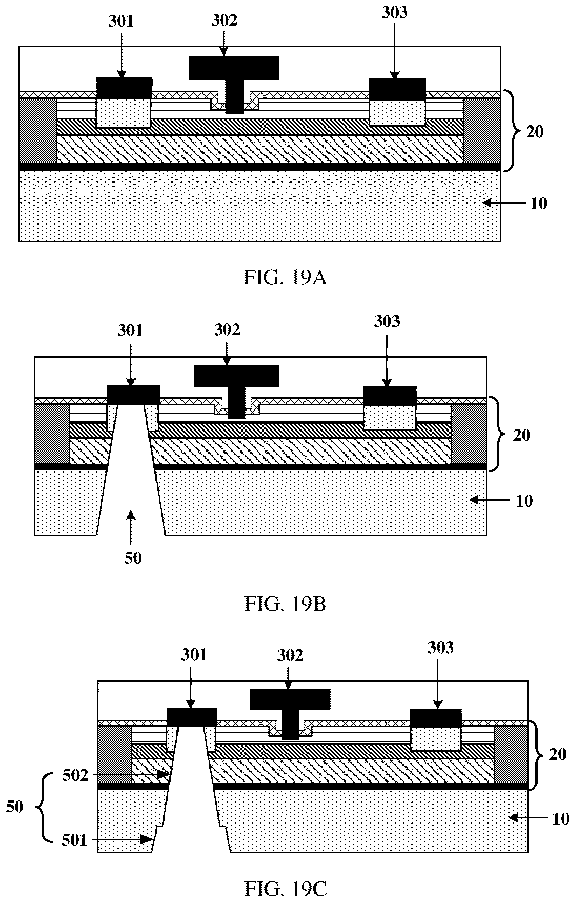

FIG. 19A to FIG. 19I show a process structure after each step in a process of preparing the field-effect transistor 101 is completed.

As shown in FIG. 19A, a to-be-processed semiconductor device is provided. A GaN HEMT device is used as an example of the to-be-processed semiconductor device shown in FIG. 19A. The device includes the substrate 10 and the active layer 20 formed on a side of the substrate 10, and the source 301, the gate 302, and the drain 303 that are formed on a side that is of the active layer 20 and that is away from the substrate 10.

As shown in FIG. 19B, deep hole etching is performed on the substrate 10 (for example, a SiC substrate) of the GaN HEMT device, and an etching depth exceeds a thickness (for example, 50 µm to 100 µm) of the substrate 10. In addition, a gallium nitride epitaxial layer is etched (that is, the gallium nitride epitaxial layer passes through the active layer 20) to reach the source 301 on the top.

As shown in FIG. 19C, a step is etched in a surface region of a deep hole of the SiC substrate, and the step makes an inner diameter of a new hole be greater than an original hole diameter. In this way, a hole structure including the first hole segment 501 and the second hole segment 502 shown in FIG. 19C may be formed. For example, when a cross section that is of the first hole segment 501 and that is perpendicular to the axial direction of the hole is elliptical, a size of a major axis that is of the first hole segment and that is close to an opening may be 50 µm to 100 µm, and a size of a minor axis may be 10 µm to 50 µm.

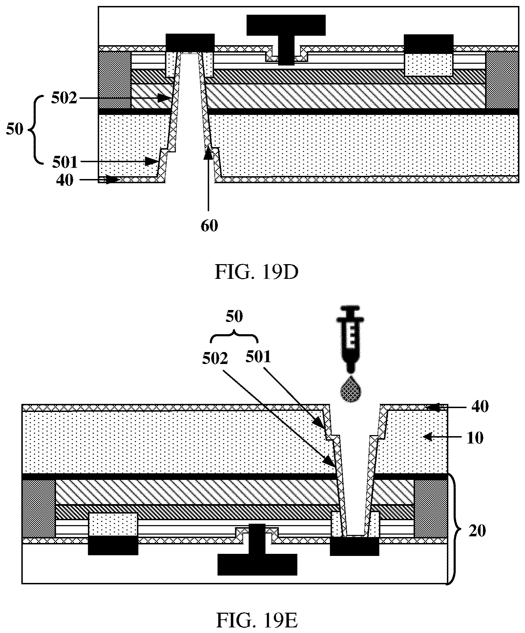

As shown in FIG. 19D, the conducting layer 60 is formed on a wall surface of the hole 50, and the back electrode 40 is formed on a side surface that is of the substrate 10 and that is away from the active layer 20. For example, an Ni material layer may be first formed on a wall surface of the hole 50 and a side surface that is of the substrate 10 and that is away from the active layer 20 through sputtering deposition, and then an Au material layer is formed on the Ni material layer by using an electroplating deposition process, to prepare the back electrode 40 and the conducting layer 60.

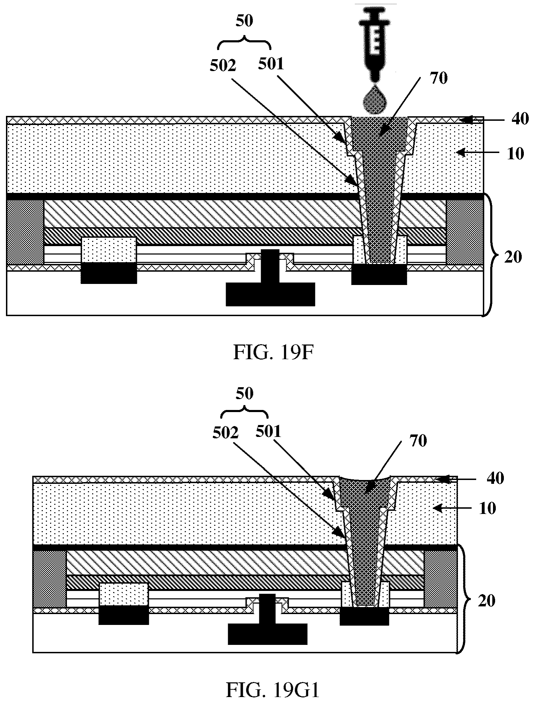

As shown in FIG. 19E and FIG. 19F, dispensing (which may also be referred to as a printing process) of a sintered silver material is performed in the hole 50. A sintered silver adhesive falls on a step and fills in the hole, and under a high-temperature negative-pressure condition, the sintered silver automatically flows into a deep hole and reaches the bottom of the hole. The sintered silver is filled in the hole of the entire device due to repeated dispensing and the negative-pressure condition.

In some implementable processes, a temperature may range from 50°C to 150°C. For example, the temperature may range from 70°C to 80°C. When pressure is less than or equal to 1000 mbar, for example, is 500 mbar to 800 mbar, dispensing of the sintered silver material is performed.

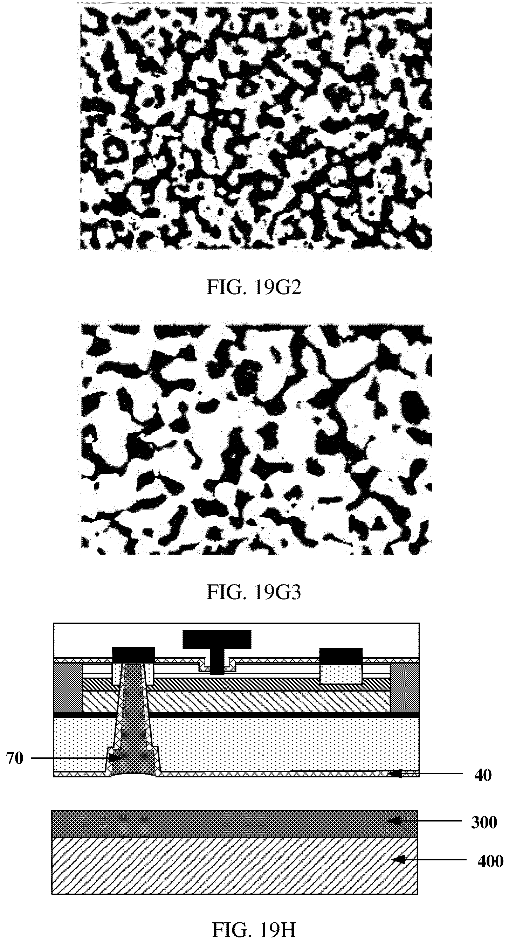

After the sintered silver fills the hole of the entire device, the sintered silver material in the hole may be cured. For example, sintering is performed at about 200°C, so that the silver material is sintered and cured. The sintered silver material is filled in the hole 50, and as shown in FIG. 19G1, the sintered silver material shrinks to a specific extent due to sintering. In addition, sintered silver of nanoparticles reacts inside a backside hole to form porous silver structure filling shown in FIG. 19G2 and FIG. 19G3.

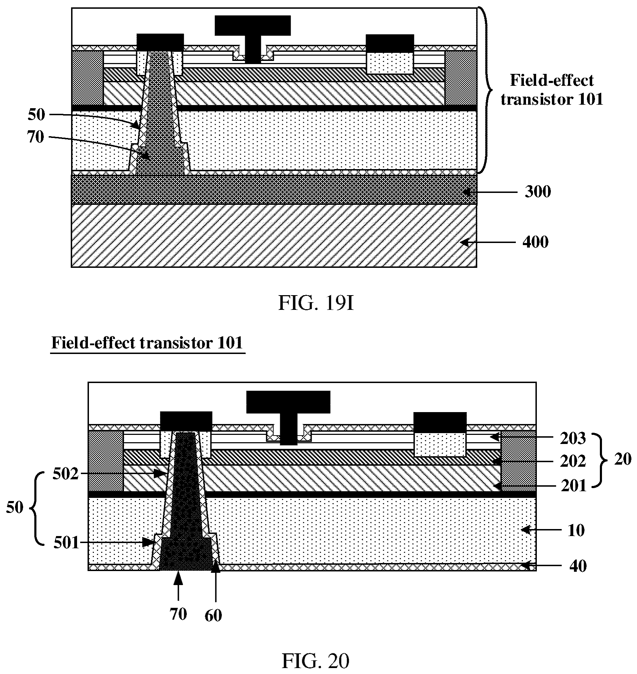

As shown in FIG. 19H, dispensing of sintered silver is performed on the heat dissipation flange 400 (for example, a copper flange) for die attaching (die attaching) of the device, and then high-temperature sintering is performed after the dispensing is completed, so that the field-effect transistor 101 and the heat dissipation flange 400 are welded. The sintered silver in the hole 50 is connected to the sintered silver for die attaching to form an effective heat dissipation channel, so as to obtain a structure shown in FIG. 19I.

In the structure prepared by using the process shown in FIG. 19A to FIG. 19I, under a high-temperature negative-pressure condition, sintered silver may be injected into the hole by using a dispensing process (which may also be referred to as a printing process). In addition, the sintered silver automatically flows into a deep hole and reaches the bottom of the hole. The sintered silver is filled in the hole of the entire device through repeated dispensing and under the high-temperature negative-pressure condition. In this way, a process flow is simple, and no additional process device needs to be further provided.

In addition, a connection layer is formed on a surface of the heat dissipation flange 400 by using a sintered silver dispensing process, so that the field-effect transistor 101 prepared in FIG. 19H is welded to the heat dissipation flange 400. In this way, sintered silver on the surface of the heat dissipation flange 400 may fill a retracted position of the sintered silver shown in FIG. 19H, and the sintered silver in the hole 50 may be connected to the sintered silver used as the connection layer, to form a heat dissipation channel with a greater area.

When the process steps shown in FIG. 19E are performed, diamond powder may be mixed in the sintered silver. For example, micrometer-level or nanometer-level diamond powder is evenly distributed inside the sintered silver, to improve overall heat dissipation performance.

In the different embodiments shown above, the heat dissipation material filled in the hole 50 includes a silver material. FIG. 20 is a diagram of another field-effect transistor 101 filled with different heat dissipation materials according to an embodiment of this application. The structure shown in FIG. 20 is the same as that in the foregoing embodiment in that the structure includes the hole 50 that penetrates the back electrode 40, the substrate 10, and the active layer 20, and a wall surface of the hole 50 is covered with the conducting layer 60. In the structure shown in FIG. 20, the heat dissipation material 70 is single crystal diamond or polycrystal diamond. For example, a thermal conductivity of the polycrystal diamond is usually greater than 1400 W/mK, so that a heat dissipation effect can be significantly improved, and a highest junction temperature of the device can be reduced.

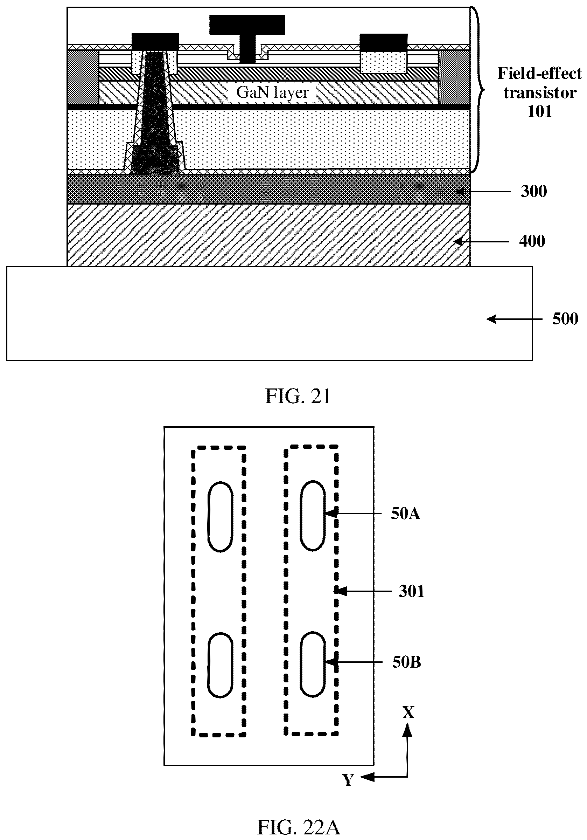

As shown in FIG. 21, the field-effect transistor 101 may be disposed on the heat dissipation flange 400 through the connection layer 300, and the heat dissipation flange 400 is disposed on the heat sink 500. The connection layer 300 may be a silver material layer made of sintered silver.

The following Table 1 shows highest temperatures of layers when different heat dissipation materials are used in the structure shown in FIG. 21.

**Table 1**

| Highest temperature of each layer | No filling | Silver material | Diamond |
|---|---|---|---|
| GaN layer | 118.5°C | 113.1°C | 103.1°C |
| SiC substrate | 115.8°C | 110.3°C | 101.7°C |
| Connection layer | 97.2°C | 96.5°C | 95.8°C |
| Heat dissipation flange | 90.9°C | 90.9°C | 90.7°C |

Based on the data in Table 1, it can be learned that when the hole 50 is not filled with the heat dissipation material, a highest temperature of the GaN layer is obviously higher than that of the GaN layer in which the heat dissipation material including the silver material and the diamond is filled. Therefore, when the silver material or the diamond material provided in this embodiment of this application is used, a highest temperature of each layer structure can be significantly reduced, thermal resistance of the device can be reduced, and a heat dissipation effect can be improved.

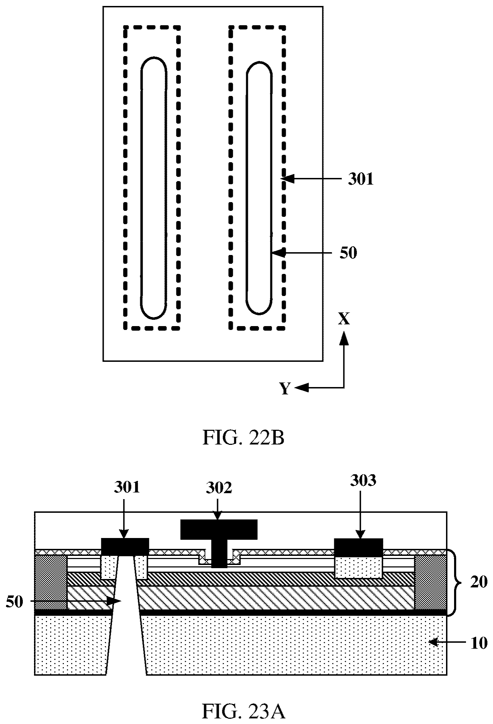

In the structure shown in FIG. 21, when the hole 50 uses two different structures in FIG. 22A and FIG. 22B and uses different heat dissipation materials, the following Table 2 shows impact on a highest junction temperature of the device. In addition, in this example, major axes of the first hole 50A and the second hole 50B whose cross sections are elliptical in FIG. 22A have major axis sizes of 50 µm to 100 µm, and minor axis sizes of 10 µm to 50 µm. The hole 50 whose cross section is elliptical in FIG. 22B has a major axis size of 100 µm to 400 µm, and a minor axis size of 10 µm to 50 µm.

**Table 2**

| | No filling | Silver material | Diamond |
|---|---|---|---|
| Example 1 | 0 | -6.9% | -19% |
| Example 2 | 0 | -11.3% | -31.9% |

Example 1 in Table 2 shows a heat gain of the device when the same source 301 is electrically connected to the back electrode through the separated hole 50 in FIG. 22A, and the silver material or the diamond material is used. For example, when the silver material is used as the heat dissipation material, the heat gain reaches (90.9/113.1)%=6.9%.

Example 2 in Table 2 shows a heat gain of the device when the same source 302 is electrically connected to the back electrode through the hole 50 in FIG. 22B and the silver material or the diamond material is used. For example, when the silver material is used as the heat dissipation material, the heat gain reaches 11.3%.

It can be learned from the data in Table 2 that, regardless of whether Example 1 or Example 2 is used, filling the hole with the silver material and the diamond material significantly reduces a temperature of the device in comparison with not filling the hole with any heat dissipation material.

The following provides a semiconductor device preparation method. In the field-effect transistor 101 prepared by using the method, a heat dissipation material in a hole includes diamond. A specific preparation process is as follows.

FIG. 23A to FIG. 23E show a process structure after each step in a process of preparing the field-effect transistor 101 is completed. In FIG. 23A to FIG. 23E, a GaN HEMT device is used as an example to describe a preparation process.

As shown in FIG. 23A, deep hole etching is performed on the substrate 10 (for example, a SiC substrate) of the GaN HEMT device, and an etching depth exceeds a thickness (for example, 50 µm to 100 µm) of the substrate 10. In addition, a gallium nitride epitaxial layer is etched (that is, the gallium nitride epitaxial layer passes through the active layer 20) to reach the source 301 on the top.

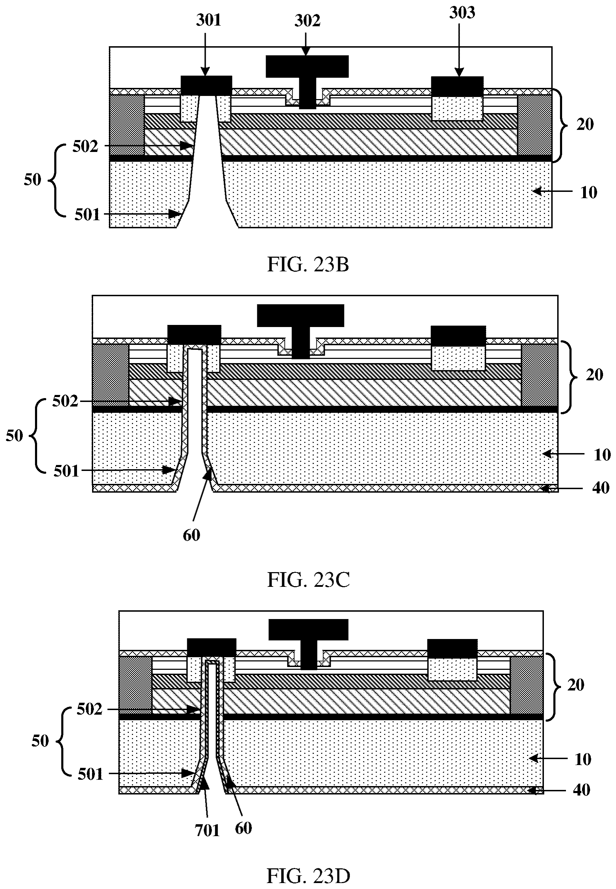

As shown in FIG. 23B, a step is etched in a surface region of a deep hole of the SiC substrate. In this way, a hole structure that includes the first hole segment 501 and the second hole segment 502 and that is shown in FIG. 23B may be formed. In FIG. 23B, there is no step at a joint between the first hole segment 501 and the second hole segment 502.

As shown in FIG. 23C, the conducting layer 60 is formed on a wall surface of the hole 50, and the back electrode 40 is formed on a side surface that is of the substrate 10 and that is away from the active layer 20.

As shown in FIG. 23D, a diamond seed layer 701 is grown on the conducting layer 60 in the hole 50.

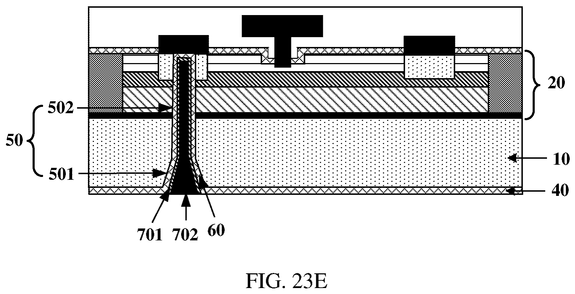

As shown in FIG. 23E, a single crystal or polycrystal diamond layer 702 is grown on the diamond seed layer 702 to fill the hole. For example, the polycrystal diamond layer 702 may be grown on the diamond seed layer 702, to reduce growth difficulty of the diamond seed layer 702.

In the semiconductor device prepared as shown in FIG. 23A to FIG. 23E, a heat gain of the device may be more than 19%, and a highest junction temperature of the device is significantly reduced.

Based on the foregoing two methods for preparing different semiconductor devices, it may be considered that the following process method may be roughly used in an implementable process.

S1: Provide a hole that penetrates a substrate and an active layer to a front electrode, where the substrate has a first surface and a second surface that are opposite to each other, the active layer is disposed on a side of the first surface, and the front electrode is disposed on a side that is of the active layer and that is away from the substrate.

S2: Expand a part that is of the hole and that is close to the second surface to form a first hole segment, where a remaining part of the hole is a second hole segment, a hole diameter of the first hole segment is greater than a hole diameter of the second hole segment, and a step is formed at a joint between the first hole segment and the second hole segment.

S3: Form a conducting layer on a wall surface of the hole, and form a back electrode on a side of the second surface, where the conducting layer is electrically connected to the back electrode. For example, when a HEMT device based on GaN is used, the back electrode is located at a ground layer to which the source is electrically connected.

S4: Fill the first hole segment and the second hole segment with a heat dissipation material, where the heat dissipation material includes at least one of a silver material and a diamond material. For example, sintered silver may be injected by using a dispensing process, or a diamond layer may be formed by using an epitaxial growth process.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A transistor, comprising:
a substrate, having a first surface and a second surface that are opposite to each other;
an active layer and a metal layer, wherein the active layer is disposed on a side of the first surface, and the metal layer is disposed on a side of the second surface; and
a hole, wherein the hole passes through the metal layer, the substrate, and at least a part of the active layer, the hole comprises a first hole segment and a second hole segment in a direction from the second surface to the first surface, a joint between the first hole segment and the second hole segment has a connection interface, and a hole diameter of the first hole segment is greater than a hole diameter of the second hole segment, wherein
a conducting layer is formed on a wall surface of each of the first hole segment and the second hole segment, and the conducting layer is electrically connected to the metal layer; and
the first hole segment and the second hole segment are further filled with a heat dissipation material.

2. The transistor according to claim 1, wherein the heat dissipation material comprises at least one of a silver material and a diamond material.

3. The transistor according to claim 2, wherein the heat dissipation material comprises the silver material and the diamond material, and a mass fraction of the silver material is greater than a mass fraction of the diamond material.

4. The transistor according to any one of claims 1 to 3, wherein a step is formed at the joint between the first hole segment and the second hole segment, and the step forms the connection interface.

5. The transistor according to any one of claims 1 to 4, wherein a bottom end that is of the first hole segment and that is away from the second surface is located in the substrate.

6. The transistor according to any one of claims 1 to 5, wherein in a stacking direction of the substrate and the active layer, a depth of the first hole segment is greater than a depth of the second hole segment.

7. The transistor according to any one of claims 1 to 6, wherein in a direction from the first surface to the second surface, the hole diameter of the first hole segment is gradually increased; and/or
in the direction from the first surface to the second surface, the hole diameter of the second hole segment is gradually increased.

8. The transistor according to any one of claims 1 to 7, wherein the transistor is a field-effect transistor;
a source, a gate, and a drain are formed on a side that is of the active layer and that is away from the substrate;
and
the hole passes through the metal layer, the substrate, and the active layer to the source, and the source is electrically connected to the metal layer through the hole filled with the conducting layer.

9. The transistor according to claim 8, wherein the gate is located between the source and the drain; and
an orthographic projection of the first hole segment on the gate covers at least a part of the gate.

10. The transistor according to claim 8 or 9, wherein the source extends in a first direction parallel to the substrate;
the hole comprises a first hole and a second hole that are separated from each other and arranged in the first direction, and both the first hole and the second hole are filled with the conducting layer and the heat dissipation material; and
the same source is electrically connected to the metal layer through the first hole and the second hole.

11. The transistor according to claim 8 or 9, wherein the source extends in a first direction parallel to the substrate;
a cross section that is of the hole and that is perpendicular to an axial direction of the hole is of a bar-shaped structure extending in the first direction; and
the same source is electrically connected to the metal layer through the hole filled with the conducting layer and the heat dissipation material.

12. The transistor according to any one of claims 1 to 11, wherein a power of the transistor is greater than or equal to 100 W.

13. A transistor preparation method, comprising:
providing a hole that penetrates a substrate and at least a part of an active layer, wherein the substrate has a first surface and a second surface that are opposite to each other, and the active layer is disposed on a side of the first surface;
expanding a part that is of the hole and that is close to the second surface to form a first hole segment, wherein a remaining part of the hole is the second hole segment, a hole diameter of the first hole segment is greater than a hole diameter of the second hole segment, and a joint between the first hole segment and the second hole segment has a connection interface;
forming a conducting layer on a wall surface of the hole, and forming a metal layer on a side of the second surface, wherein the conducting layer is electrically connected to the metal layer; and
filling the first hole segment and the second hole segment with a heat dissipation material.

14. The transistor preparation method according to claim 13, wherein filling the first hole segment and the second hole segment with the heat dissipation material comprises:
filling the first hole segment and the second hole segment with sintered silver through dispensing; and
curing the sintered silver to form a silver material layer in the first hole segment and the second hole segment.

15. The transistor preparation method according to claim 14, wherein when the first hole segment and the second hole segment are filled with the sintered silver through the dispensing, the sintered silver is doped with diamond.

16. The transistor preparation method according to claim 14 or 15, wherein filling the sintered silver through the dispensing comprises:
under a negative-pressure condition, enabling the dropped sintered silver to flow into the hole.

17. The transistor preparation method according to claim 13, wherein filling the first hole segment and the second hole segment with the heat dissipation material comprises:
forming a diamond seed layer on the conducting layer in a radial direction of the first hole segment and the second hole segment; and
forming a diamond layer on the diamond seed layer.

18. The transistor preparation method according to any one of claims 13 to 17, wherein a source, a gate, and a drain are formed on a side that is of the active layer and that is away from the substrate, and the source extends in a first direction parallel to the substrate; and
providing the hole that penetrates the substrate and at least a part of the active layer comprises:
providing a bar-shaped hole extending in the first direction, for the same source to electrically connect to the metal layer through the bar-shaped hole filled with the conducting layer.

19. A semiconductor device package structure, comprising:
the transistor according to any one of claims 1 to 12, or the transistor prepared by using the transistor preparation method according to any one of claims 13 to 18; and
a heat dissipation structure, wherein the heat dissipation structure is disposed on a side of the second surface of the substrate.

20. The semiconductor device package structure according to claim 19, wherein the heat dissipation structure is connected through a silver material layer located between the heat dissipation structure and the metal layer, and the heat dissipation material in the hole is connected to the silver material layer.

21. The semiconductor device package structure according to claim 19 or 20, wherein the semiconductor device package structure further comprises:
a cap, wherein the cap covers a side that is of the transistor and that is away from the heat dissipation structure.

22. An electronic device, comprising:
a drive circuit; and
the semiconductor device package structure according to any one of claims 19 to 21, wherein
the transistor in the semiconductor device package structure is electrically connected to the drive circuit.
